# EUROPEAN PATENT APPLICATION

(11) **EP 3 181 718 A1**
(43) Date of publication of application: **21.06.2017**
(21) Application number: 15307017.2
(22) Date of filing: 15.12.2015
(51) Int. Cl.: C23C 10/38, C23C 10/54, C23C 14/35, C23C 16/10, C23C 28/02, G21C 3/07, G21C 3/20

(54) **CLADDING FOR A FUEL ROD FOR A LIGHT WATER REACTOR**

(71) Applicant: AREVA NP, 92400 Courbevoie (FR)
(72) Inventor: HERTZ, Dominique, 69110 Sainte-Foy-Les-Lyon (FR); BISCHOFF, Jérémy, 69003 Lyon (FR); GUILLERMIER, Pierre, 69007 Lyon (FR)
(74) Representative: Lavoix

(57) **Abstract**

Fuel rod cladding (4) for a light water reactor, comprising :
a core (16) comprising a matrix consisting of pure molybdenum or of a molybdenum-based alloy ; and
an outer protective layer (18), said outer protective layer (18) being selected among:
- a chromium-based coating (20) deposited on an outer surface of said core layer (16), said chromium-based coating (20) comprising at least one chromium-based coating layer (24) consisting of pure chromium or of a chromium-based alloy ;
- a chromium-based diffusion layer (22) obtained by diffusion of chromium into the core (16) from the outer surface of the core (16) ;
- a succession of a chromium-based diffusion layer (22) obtained by diffusion of chromium into the core (16) from the outer surface of the core (16) and a chromium-based coating (20) consisting of chromium or of a chromium-based alloy deposited on the

## Description

The present invention relates to a cladding tube for a nuclear fuel rod for a light water reactor.

Cladding tubes for nuclear fuel rods intended for light water reactor (LWR) are usually made of a zirconium-based alloy. Such alloys achieve a highly reliable performance under normal operating conditions of the nuclear reactor. However, they may have a poor behavior under severe accident conditions, particularly in the event of a loss of coolant accident without security injection. Indeed, in high pressure steam conditions, the zirconium alloy cladding will undergo rapid oxidation or corrosion, producing intense heat and hydrogen. At high temperatures, and in particular at temperatures above 800°C, which may occur in accident conditions, the zirconium alloy cladding may further suffer a reduction of its tensile and creep strength, which may result in a deformation or even in a burst of the fuel rods, which can impact reactor core coolability.

Patent application US 2015/0063522 discloses a nuclear fuel rod cladding comprising a core consisting of molybdenum or of a molybdenum-based alloy. The cladding further comprises a protective coating formed on an outer surface of the core and consisting of a zirconium-based alloy or of an aluminum containing stainless steel. The protective coating is deposited on the outer surface of the core by a coating process, such as physical vapor deposition (PVD), inert gas spray, vacuum plasma spray, high velocity oxi-fuel (HVOF) or high velocity air fuel (HVAF).

Such a fuel rod cladding is not entirely satisfactory.

Indeed, the protection behavior of the coating against corrosion depends on its composition, as well as on its microstructure. In particular, the composition of the coating should be and remain in a specified range at each location of the surface of the cladding during the fuel assembly lifetime.

Using deposition methods such as HVOF, HAVF, PVD, inert gas spray or vacuum plasma spray for depositing a protective coating consisting of a zirconium-based alloy or of an aluminum containing stainless steel as disclosed in US 2015/0063522 does not guarantee achieving the chemical composition and microstructure allowing for a satisfactory protection against corrosion.

In particular, when using such deposition methods to coat a component with a zirconium-based alloy or an aluminum containing stainless steel, it is difficult to guarantee the homogeneity of the coating composition on the whole surface of the cladding and during the entire deposition process.

US 2015/0063522 also discloses, as an alternative, manufacturing the cladding tube through mechanical co-reduction, for example through co-extrusion, co-milling or co-drawing. However, using such method, it is difficult to obtain the desired microstructure in all the layers of the cladding.

Indeed, the mechanical and heat treatment conditions cannot be generally optimized for both the core material and the outer protective material.

Using zirconium-based alloy or of an aluminum containing stainless steel for protecting the molybdenum core against corrosion is further not satisfactory for the following reasons.

Aluminum oxides, which result from the oxidation of the aluminum containing stainless steel coating during the operation of the nuclear reactor, dissolve slowly in water above 300°C. In normal operating conditions, this will lead to a decrease of aluminum content at the surface of the aluminum containing stainless steel coating and therefore to a loss of corrosion protection. In addition, aluminum oxides swell under irradiation potentially leading to cracks in the protective coating and therefore also to a loss of corrosion protection.

Zirconium, for its part, reacts exothermically with high temperature steam to produce hydrogen and heat in large quantities. Therefore, the zirconium-based alloy protective layer does not add operating margins under severe accident conditions as compared to a conventional zirconium-based cladding.

Consequently, with the protective coatings disclosed in US 2015/0063522, there is a risk of oxidation and corrosion of the no longer efficiently protected molybdenum core layer, which may, ultimately, result in a loss of integrity of the cladding.

One purpose of the invention is to provide fuel rod cladding tubes which have an improved behavior under normal and accident conditions.

To that end, the invention relates to a fuel rod cladding for a light water reactor, comprising :
a core comprising a matrix consisting of pure molybdenum or of a molybdenum-based alloy ; and
an outer protective layer, said outer protective layer being selected among:
   - a chromium-based coating deposited on an outer surface of said core layer, said chromium-based coating comprising at least one chromium-based coating layer consisting of pure chromium or of a chromium-based alloy ;
   - a chromium-based diffusion layer obtained by diffusion of chromium into the core from the outer surface of the core ;
   - a succession of a chromium-based diffusion layer obtained by diffusion of chromium into the core from the outer surface of the core and a chromium-based coating consisting of chromium or of a chromium-based alloy deposited on the outer surface of said core.

According to specific embodiments of the fuel rod cladding :
- the core further comprises particles dispersed within the matrix of pure molybdenum or of molybdenum-based alloy;
- the core consists of the matrix of pure molybdenum or of molybdenum-based alloy;
- the molybdenum-based alloy comprises at least 85 wt.% of molybdenum;
- the chromium-based diffusion layer is obtained through chromizing by pack cementation using a powder mixture comprising metallic chromium, and advantageously at least 15 wt.% of metallic chromium, or by chemical vapor deposition;
- the chromium-based coating is obtained through physical vapor deposition or through chemical vapor deposition;
- the chromium-based diffusion layer is obtained through heat treatment of the chromium-based coating deposited on the outer surface of the core;
- the outer protective layer has a thickness comprised between 2 µm and 100 µm ;
- the fuel rod cladding further comprises an inner protective layer, said inner protective layer being selected among:
- a chromium-based coating deposited on an inner surface of the core layer, said chromium-based coating consisting of pure chromium or of a chromium-based alloy ;
- a chromium-based diffusion layer obtained by diffusion of chromium into the core from the inner surface of the core.

The invention further relates to a fuel rod comprising a fuel rod cladding as defined above.

The invention further relates to a method for producing a fuel rod cladding as defined above, comprising steps of:
- providing a core comprising a matrix consisting of pure molybdenum or of a molybdenum-based alloy; and
- forming an outer protective layer, the step of forming an outer protective layer comprising at least one of the following steps:
- depositing a chromium-based coating consisting of pure chromium or of a chromium-based alloy on an outer surface of said core, said deposition step comprising depositing at least one chromium-based coating layer; and/or
- forming a chromium-based diffusion layer by diffusion of chromium into the core from the outer surface of the core.

According to particular embodiments of the method for producing the fuel rod cladding:
- the step of forming the chromium-based diffusion layer comprises chromizing by pack cementation, using a powder mixture comprising metallic chromium, and advantageously comprising at least 15 wt.% of metallic chromium;
- said powder mixture further comprises one or more diffusion elements to improve the corrosion resistance;
- the step of forming the chromium-based diffusion layer comprises chromizing through chemical vapor deposition;
- the step of depositing the chromium-based coating comprises depositing at least one chromium-based coating layer of the chromium-based coating through chemical vapor deposition or through physical vapor deposition ;
- the chromium-based coating consists of several superposed chromium-based coating layers and the step of depositing the chromium-based coating comprises depositing each chromium-based coating layer of the chromium-based coating through chemical vapor deposition or through physical vapor deposition;
- at least one chromium-based coating layer of the chromium-based coating is deposited on the outer surface of the core prior to forming the chromium-based diffusion layer, and the step of forming the chromium-based diffusion layer comprises a heat treatment of said at least one chromium-based coating layer of the chromium-based coating, the heat treatment being advantageously carried out at a temperature of at least 900°C;
- the step of depositing the chromium-based coating comprises depositing several coating layers, at least some of the steps of depositing a coating layer comprising subjecting said coating layer to a heat treatment such that chromium from said coating layer diffuses into an underlying coating layer and/or into the core, the diffusion into the core possibly coinciding with the step of forming the chromium-based diffusion layer.

The invention and its advantages will be better understood upon reading the following description, given solely by way of example and with reference to the appended drawings, in which:
- Fig. 1 is a schematic longitudinal sectional view of a fuel rod of a light water reactor according to the invention;
- Fig. 2 is a cross-sectional view of a fuel rod cladding according to one embodiment;
- Fig. 3 is a micrograph of a layer of pure molybdenum coated with pure chromium; and
- Fig. 4 is an experimental graph obtained during a corrosion test.

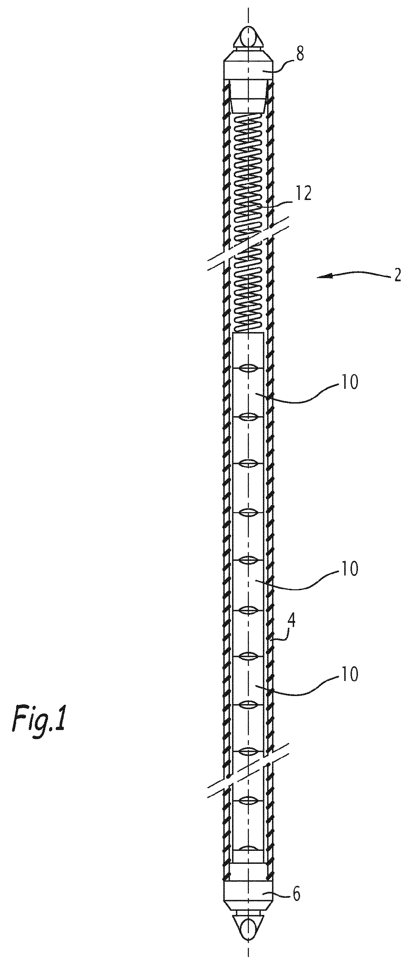

Fig. 1 illustrates an example of a nuclear fuel rod 2 for a light water reactor. Such a fuel rod is, in particular, intended for a pressurized water reactor (PWR) or for a boiling water reactor (BWR).

The nuclear fuel rod 2 comprises a cladding 4 in the form of a tube having a circular cross-section closed by a lower plug 6 at its lower end and by an upper plug 8 at its upper end. The nuclear fuel rod 2 contains the nuclear fuel for example in the form of a series of pellets 10 stacked in the cladding 4 and bearing against the lower plug 6. A holding spring 12 is positioned in the upper segment of the cladding 4 in order to bear upon the upper plug 8 and upon the upper pellet 10.

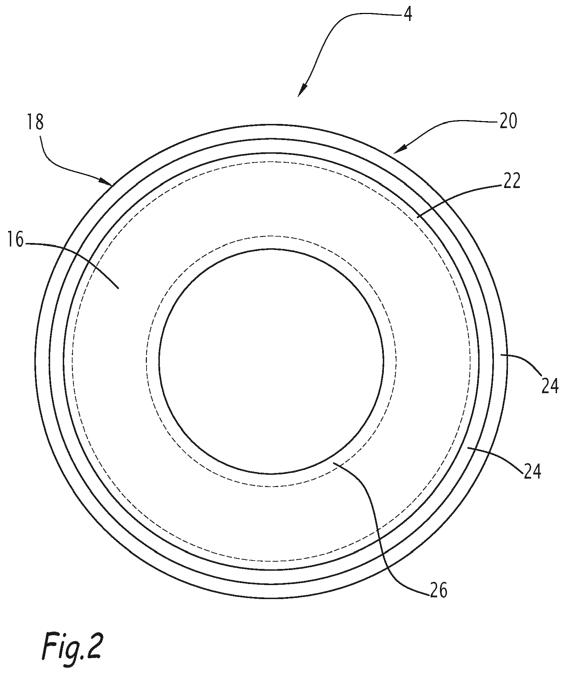

As shown in Fig. 2, the fuel rod cladding 4 comprises a core 16 and an outer protective layer 18 on the outer side of the core 16.

The core 16 comprises a matrix consisting of pure molybdenum or of a molybdenum-based alloy.

In this context, pure molybdenum is to be understood as a metal comprising at least 99 wt.% of molybdenum.

The molybdenum-based alloy is an alloy which has a molybdenum content greater than 50 wt.%. Preferably, the molybdenum-based alloy has a molybdenum content of at least 85 wt.%.

According to one embodiment, the core 16 consists of the matrix consisting of pure molybdenum or of the matrix of molybdenum-based alloy. In other words, the core 16 consists of pure molybdenum or of molybdenum-based alloy as defined above.

According to an alternative, the core 16 may comprise additional compounds dispersed in the matrix, for example for strengthening the core 16.

In particular, the core 16 may comprise particles comprising oxides, carbides or nitrides of metallic elements dispersed within the matrix. These particles for example have a diameter comprised between 5 and 500 nm. The metallic elements may be zirconium, hafnium, titanium, niobium, tantalum, silicon, yttrium or other rare earth elements.

The additional compounds strengthen the matrix consisting of pure molybdenum or of molybdenum-based alloy. For instance, in the case where the additional compounds are oxides, the core 16 consists of oxide dispersion strengthened molybdenum or of an oxide dispersion strengthened molybdenum-based alloy (also called ODS Mo or ODS Mo alloy) depending on whether the matrix is a pure molybdenum matrix or a molybdenum-based alloy matrix.

The core 16 for example has a thickness comprised between 150 and 600 µm.

The outer protective layer 18 is preferably a thin layer having a thickness smaller or equal to 100 µm. For example, the outer protective layer 18 has a thickness comprised between 2 µm and 100 µm.

Preferably, the outer protective layer 18 has a thickness smaller or equal to 50 µm. For example, the outer protective layer 18 has a thickness comprised between 5 µm and 50 µm.

The outer protective layer 18 preferably forms the outermost layer of the fuel rod cladding 4. It is thus in direct contact with the environment of the fuel rod 2.

The outer protective layer 18 is selected among:
- a chromium-based coating 20 deposited on an outer surface of said core 16, said chromium-based coating 20 consisting of pure chromium or of a chromium-based alloy ;
- a chromium-based diffusion layer 22 obtained by diffusion of chromium into the core 16 from the outer surface of the core 16;- a succession of a chromium-based diffusion layer 22 obtained by diffusion of chromium into the core 16 from the outer surface of the core 16 and a chromium-based coating 20 consisting of chromium or of a chromium-based alloy.

In the context of the invention, pure chromium is to be understood as a metal comprising at least 99 wt.% of chromium.

A chromium-based alloy is an alloy having a chromium content greater than 50 wt.%. Preferably, the chromium-based alloy has a chromium content greater or equal to 85 wt.%.

The chromium-based coating 20 advantageously has a thickness smaller or equal to 50 µm, for example comprised between 2 µm and 50 µm, and preferably comprised between 5 µm and 30 µm.

Within these thicknesses, the chromium-based coating 20 does not form cracks or fissures.

The chromium-based coating 20 may comprise only one or several superposed chromium-based coating layers 24.

Each chromium-based coating layer 24 consists of chromium or of a chromium-based alloy. The chromium-based coating layers 24 may have a same composition or a different composition.

For example, each chromium-based coating layer 24 has a thickness smaller or equal to 50 µm, preferably comprised between 10 nm and 50 µm.

The chromium-based diffusion layer 22 extends into the core 16 from the outer surface of the core 16.

In this context, the expression « chromium-based » is intended to mean that chromium is the main element that diffuses into the core 16.

The inner limit of the diffusion layer 22 within the core material is defined as the maximum depth into the core 16 at which the chromium content in the core material is still equal to at least 2 wt.%.

Preferably, the chromium-based diffusion layer 22 has a thickness, or depth, smaller or equal to 50 µm, for example comprised between 5 µm and 30 µm, and even more preferably comprised between 10 µm and 30 µm.

In the embodiment shown in Fig. 2, the outer protective layer 18 comprises a chromium-based diffusion layer 22 and a chromium-based coating 20. The chromium-based coating 20 extends radially exteriorly to the chromium-based diffusion layer 22. The chromium-based coating 20 delimits the outer surface of the cladding 4.

In the embodiment shown in Fig. 2, the fuel rod cladding 4 further comprises an inner protective layer 26. This inner protective layer 26 is formed on an inner side of the core 16.

The inner protective layer 26 protects the inner surface of the core 16 against corrosion, which may result from the entry of water into the cladding 4 during operation of the reactor due to, for example, manufacturing defects (welding...) or in-service failure of the fuel rod 2 (fretting, debris wear...).

The inner protective layer 26 also protects the inner surface of the core 16 against the oxidation induced by the oxygen released from the fissile material (UO₂, PUO₂) of the fuel pellet 10.

The inner protective layer 26 also protects the inner surface of the core 16 against abrasion induced by fuel pellets 10 loading into the cladding 4 during the manufacturing of the fuel rod 2.

The inner protective layer 26 is preferably a thin layer having a thickness smaller than 50 µm. For example, the inner protective layer 26 has a thickness smaller or equal to 50 µm, preferably comprised between 5 µm and 50 µm.

The inner protective layer 26 is a chromium-containing layer.

It is advantageously a chromium-based diffusion layer obtained by diffusion of chromium into the core 16 from an inner surface of the core 16. This diffusion layer extends into the core 16 from the inner surface of the core 16.

The inner limit of this diffusion layer 26 within the core material is defined as the maximum depth into the core 16 at which the chromium content in the core material is still equal to at least 2 wt.%.

According to an alternative, the inner protective layer 26 is a coating formed on the inner surface of the core 16. Advantageously, this coating consists of pure chromium or of a chromium-based alloy.

A method for producing a fuel rod cladding 4 as described above will now be explained.

This method comprises:
- providing a core 16 comprising a matrix consisting of pure molybdenum or of molybdenum-based alloy; and
- forming an outer protective layer 18 on said core 16, said outer protective layer 18 being chosen among the outer protective layers 18 mentioned above.

More particularly, the step of forming an outer protective layer 18 comprises one or more of the following steps:
- depositing a chromium-based coating 20 consisting of pure chromium or of a chromium-based alloy on the outer surface of the core 16, and/or
- forming a chromium-based diffusion layer 22 by diffusion of chromium into the core 16 from the outer surface of the core 16.

As will be seen later, these steps are not necessarily carried out in the order in which they appear above.

More particularly, the step of depositing a chromium-based coating 20 advantageously comprises a physical vapor deposition (also called PVD) or a chemical vapor deposition (also called CVD) step.

Physical vapor deposition is advantageous, as it is quick to implement and allows the production of the coating at a moderate temperature, for example comprised between 50°C to 700°C.

Preferably, sputtering is used as the physical vapor deposition method. During sputtering, inert gas ions accelerated under high voltage impinge on a target, thus ejecting atoms from the target, the ejected atoms then forming a metal vapor that condenses on the surface of a substrate to form a coating.

Even more preferably, the chromium-based coating 20 is deposited onto the outer surface of the core 16 using a high power impulse magnetron sputtering physical vapor deposition technique.

In this technique, a set of permanent magnets forming a magnetron is located under the target in order to increase the ion density in the vicinity of the target. The magnetron effect helps maintain the discharge with a lower pressure, thereby improving the sputtering quality.

The high power impulse magnetron sputtering physical vapor deposition technique is known to the skilled person and will not be described in further detail in this patent application.

The skilled person is able, using his general knowledge, to determine the composition of the target that will allow obtaining the desired coating composition and the operating conditions, mainly the pressure and polarization.

Using the high power impulse magnetron sputtering physical vapor deposition technique for depositing the chromium-based coating 20 is advantageous, as it enables the deposition of a thin, dense, highly adherent coating which therefore provides for an improved protection of the underlying layer(s) or the underlying core 16.

In the case where the step of depositing the chromium-based coating 20 is a chemical vapor deposition step (CVD), the CVD is advantageously carried out using molybdenum, hydrogen or zinc vapor as reducing agent.

The CVD is advantageously performed under atmosphere containing chromium precursors as chromium halides or chromium metal-organic compounds, at a temperature in the range of 900°C-1200°C for several hours by batch treatment or in the range of 1000-1600°C for at least a few minutes by continuous treatment.

Chemical vapor deposition (CVD) is advantageous, as it allows performing the chromium coating simultaneously on the inner and the outer surfaces of the core 16.

In the case where the chromium-based coating 20 comprises several superposed coating layers 24, the step of depositing the chromium-based coating 20 comprises as many steps of depositing a coating layer 24 as there are layers 24 in the chromium-based coating 20.

Optionally, the step of forming the outer protective layer 18 further comprises, following the deposition of the chromium-based coating 20, a step of subjecting said chromium-based coating 20 to a diffusion heat treatment so as to enhance the adherence of the outer protective layer 18.

This heat treatment is advantageously performed under vacuum or under inert gas atmosphere at a temperature in the range of 900°C to 1200°C and for a duration comprised between a few minutes and several hours. The heat treatment can be performed by batch or continuously.

The chromizing step, also known as "chromatization", i.e. the step of forming the chromium-based diffusion layer 22 comprises, for example, a step of chromizing by pack cementation.

The chromizing process by pack cementation is carried out at high temperature, and particularly at temperatures between 900°C and 1250°C using a powder mixture comprising metallic chromium.

Advantageously, the powder mixture comprises at least 15 wt.% of metallic chromium, and preferably between 15 wt.% and 30 wt.% of metallic chromium.

The pack cementation is carried out by placing the core 16 with the powder mixture in the same hot cell.

Upon heating the powder mixture and the core 16 contained therein at the desired treatment temperature during a specific treatment time, which depends on the thickness of the diffusion layer to be obtained, a diffusion layer will form at least at the outer surface of the core 16.

The pack cementation treatment is carried out under an inert or reducing atmosphere, such as, for example, argon or hydrogen.

The skilled person is able, using his general knowledge, to determine the composition of the powder mixture, as well as the treatment time that will allow obtaining the desired diffusion layer composition and thickness.

For example, the powder mixture consists of a source metal consisting of chromium, an activator and an inert filler. In this case, the chromium-based diffusion layer 22 is obtained by diffusion of only chromium through the core 16.

The activator for example comprises at least 2 wt.% of Na or NH₄⁺ halide.

The inert filler for example comprises alumina or zirconia.

The activator and the inert filler may each consist of only one type of activator or inert filler or they may each comprise a mixture of inert fillers or of activators.

According to one embodiment, the powder mixture consists of chromium and an activator, the balance being constituted by inert filler.

According to an alternative, the diffusion layer is obtained by co-diffusion.

In this case, the powder mixture further comprises one or more diffusion elements, which may for example include niobium, tantalum, nitrogen, rare earth elements, silicon or/and oxygen.

Forming the chromium-based diffusion layer 22 through co-diffusion is advantageous, as it allows obtaining a more efficient diffusion layer as compared to the case where only chromium diffuses into the core 16. It therefore results in an even further improved corrosion resistance of the fuel rod cladding 4.

According to an alternative, the chromizing step, i.e. the step of forming the chromium-based diffusion layer 22 comprises a step of chromizing through chemical vapor deposition (CVD).

For example, the CVD is carried out using the molybdenum of the core 16 as a reducing agent.

The CVD is advantageously performed under an atmosphere containing chromium precursors such as chromium halides or chromium metal-organic compounds, at a temperature in the range of 900-1200°C for several hours by batch treatment or in the range of 1000-1600°C for at least a few minutes by continuous treatment.

In the embodiment where the outer protective layer 18 comprises both a chromium-based diffusion layer 22 and a chromium-based coating 20, the method for manufacturing the cladding 4 may successively comprise:
- a step of forming the diffusion layer by chromizing through pack cementation or CVD , and
- a step of depositing the chromium-based coating 20 onto the outer surface of the core 16 using any one of the coating deposition steps described above.

This coating deposition step may optionally be followed by a diffusion heat treatment step for enhancing the adherence of the coating as described above.

In the embodiment where the outer protective layer 18 comprises both a diffusion layer 22 and a chromium-based coating 20, according to an alternative, the chromium-based diffusion layer 22 may be obtained by diffusion of chromium from the chromium-based coating 20 deposited on the outer surface of the core 16.

In this case, the method for manufacturing the cladding 4 may successively comprise:
- the deposition of at least a portion of the chromium-based coating 20, and for example of one chromium-based layer 24 of the chromium-based coating 20 onto the outer surface of the core 16 ; and
- the formation of the chromium-based diffusion layer 22.

According to this alternative, the step of forming the chromium-based diffusion layer 22 is a step of heat treating the at least one portion, and more particularly the at least one chromium-based layer 24 of the chromium-based coating 20.

This heat treatment is advantageously carried out at a temperature greater than 900°C, and more particularly comprised between 950°C and 1200 °C. It is carried out for a duration depending on the thickness of the chromium-based diffusion layer 22 to be formed and/or on the decision to perform a partial or a full diffusion of the chromium-based coating 20.

During this heat treatment, in the case where the chromium-based coating 20 consists of a chromium-based alloy, in addition to the chromium, one or more additional elements, in this case other alloying elements from the chromium-based alloy, may diffuse into the core 16.

In the case where the chromium-based coating 20 comprises more than one chromium-based coating layer 24, at least some of the steps of depositing a chromium-based coating layer 24 comprise subjecting said chromium-based coating layer 24 to a heat treatment such that chromium from said chromium-based coating layer 24 diffuses into an underlying coating layer 24 and/or into the core 16.

For example, each step of depositing a chromium-based coating layer 24 comprises such a heat treatment.

In the case where the diffusion heat treatment is applied to the first coating layer 24 deposited onto the outer surface of the core 16, this heat treatment sub-step may coincide with the step of forming the diffusion layer 22 by diffusion of chromium from the chromium-based coating 20.

The composition of the successive coating layers 24 may be the same or it may be different.

For instance, the composition of the innermost coating layer 24 of the chromium-based coating 20 may be determined to optimize the diffusion conditions or the diffusion rate or length of the chromium from the innermost coating layer into the core 16 while the composition of the outermost coating layer 24 is determined to optimize the corrosion protection properties of the coating.

According to an advantageous embodiment, a chromium-based diffusion layer 22 is formed through CVD chromizing method using the treatment parameters disclosed above for producing such a diffusion layer. A chromium-based coating 20 is then formed on the outer surface of the core 16 through CVD using the treatment parameters disclosed above for producing such a coating. Finally, a heat treatment for enhancing the adherence of the coating is performed on the chromium-based coating 20 using the treatment parameters disclosed above.

CVD is advantageous, as it allows carrying out, successively, a thermo-chemical treatment (chromizing) for producing a chromium-based diffusion layer 22, a coating treatment for producing the chromium-based coating 20 and a final heat treatment in the same furnace without any handling of the materials.

The method may further comprise a step of forming an inner protective layer 26 at the inner surface of the core 16.

This step advantageously comprises the diffusion of chromium into the core 16 from the inner surface.

For example, this diffusion is obtained through a pack cementation method as disclosed above.

Advantageously, this diffusion is obtained through chemical vapor deposition using the chromizing treatment parameters disclosed above.

In the case where the step of forming the chromium-based diffusion layer 22 comprises the formation of a diffusion layer through CVD, the step of forming the chromium-based diffusion layer 22 and the step of forming the inner protective layer 26 may be carried out simultaneously through one single step of CVD.

According to an alternative, the inner protective layer 26 is a coating consisting of pure chromium or of a chromium-based alloy formed on the inner surface of the core 16. In this case, the step of forming an inner protective layer 26 comprises a step of depositing said coating on the inner surface of the core 16, preferably through CVD. In particular, the CVD is carried out using the conditions disclosed above for depositing a CVD coating on the outer surface of the core 16.

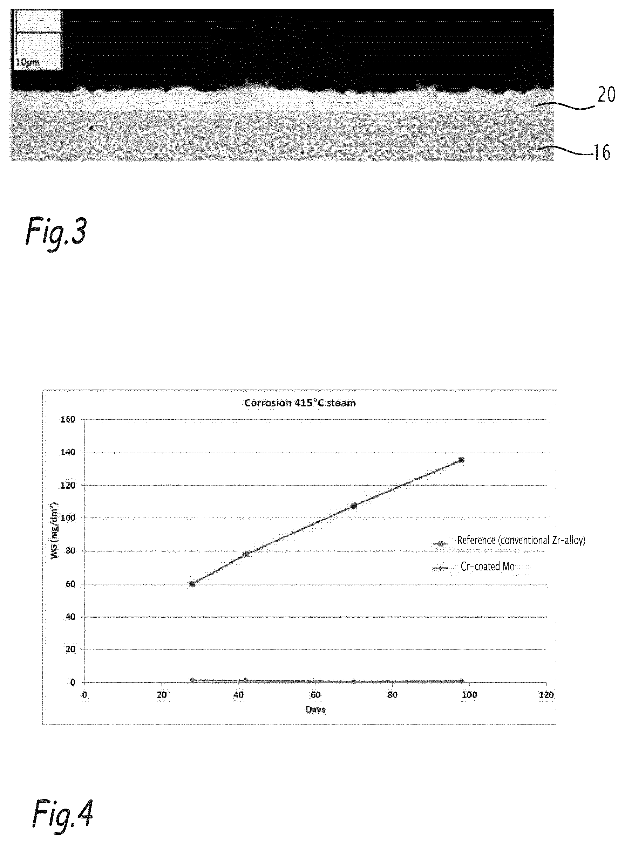

The inventors produced a 5 µm thick coating consisting of pure chromium on a sample comprising a substrate consisting of pure molybdenum. Fig. 3 is a micrograph of this sample taken at the interface between the coating and the molybdenum substrate.

An oxidation test was performed in 415°C steam for a given period of time and the weight gain Wg was measured as a function of time. A sample consisting of a conventional uncoated zirconium alloy was taken as a reference.

The graph of Fig. 4 shows the weight change Wg of the sample during oxidation as a function of the oxidation time.

As can be seen from this graph, no significant amount of corrosion can be observed with the sample according to the invention, while a high amount of corrosion occurs with the reference sample.

The fuel rod cladding 4 according to the invention is particularly advantageous.

Indeed, the core 16 comprising a matrix consisting of pure molybdenum or of a molybdenum alloy results in improved mechanical properties of the fuel cladding at high temperature, thus preserving the coolable geometry of the fuel assemblies under severe accident conditions.

Furthermore, having an outer protective layer 18 as defined above leads to a very good corrosion resistance of the cladding and improves the corrosion behavior under normal and accident conditions. In particular, it protects the molybdenum against corrosion under normal operating conditions, where the cladding is immersed in coolant. Under these conditions, unprotected molybdenum or molybdenum alloy exhibits high corrosion kinetics and forms a non-protective oxide.

The use of chromium protected molybdenum or molybdenum-based alloys for the LWR fuel rod cladding tube 4 provides at least the same corrosion performances as current zirconium-based claddings in normal operations and increased margins (increased coping time) under severe accident conditions due to the molybdenum high melting temperature (around 2623°C for pure molybdenum), its mechanical properties at high temperature and its oxidation kinetics in high temperature steam.

The outer protective layer 18 further provides for an improved accident tolerance as compared to a zirconium alloy coating layer or an aluminum containing steel layers, such as disclosed in US 2015/0063522. Indeed, since the chromium-molybdenum eutectic occurs at a temperature of 1820°C, which is above the iron-molybdenum eutectic (around 1400°C) or the zirconium-molybdenum eutectic (around 1550°C), the chromium based outer layer according to the invention will retain its integrity for higher temperatures than the coating disclosed in US 2015/0063522, thus reducing the risk of a corrosion of the molybdenum-based core at temperatures above 1550°C, which may be reached under severe accident conditions, and in particular during a loss of coolant type accident without any safety injection.

Moreover, compared to existing solutions, the corrosion protection provided by a protective layer 18, 26 according to the invention only depends on the content of chromium in the layer 18, 26 and does not depend on the composition and/or the microstructure of the layer 18, 26. In addition, chromium oxide induced by the oxidation of the metallic chromium of the protective layer 18, 26 by the reactor coolant does not react with the other materials of the fuel assembly under normal and accident operating conditions and does not undergo rapid oxidation or corrosion, and therefore produce hydrogen in high pressure steam conditions.

Providing an outer protective layer 18 comprising a chromium-based diffusion layer 22 offers the further advantage of bringing the increased corrosion resistance directly into the core 16. Consequently, issues such as localized fabrication defects, which might result from a coating process, can be significantly reduced.

The corrosion resistance of the cladding 4 is even further improved if the cladding 4 comprises a protective inner layer 26, which protects the cladding from corrosion due to water which may have entered the cladding tube, for example due to an imperfect water tightness thereof or to a mechanical failure of the fuel rod.

Finally, providing an outer protective layer 18 comprising several superimposed coating layers and heat treating these layers as they are deposited reduces the risks linked to fabrication or interface defects.

## Claims

1. Fuel rod cladding (4) for a light water reactor, comprising :
a core (16) comprising a matrix consisting of pure molybdenum or of a molybdenum-based alloy ; and
an outer protective layer (18), said outer protective layer (18) being selected among:
- a chromium-based coating (20) deposited on an outer surface of said core layer (16), said chromium-based coating (20) comprising at least one chromium-based coating layer (24) consisting of pure chromium or of a chromium-based alloy ;
- a chromium-based diffusion layer (22) obtained by diffusion of chromium into the core (16) from the outer surface of the core (16) ;
- a succession of a chromium-based diffusion layer (22) obtained by diffusion of chromium into the core (16) from the outer surface of the core (16) and a chromium-based coating (20) consisting of chromium or of a chromium-based alloy deposited on the outer surface of said core (16).

2. Fuel rod cladding (4) according to claim 1, wherein the core (16) further comprises particles dispersed within the matrix of pure molybdenum or of molybdenum-based alloy.

3. Fuel rod cladding (4) according to claim 1, wherein the core (16) consists of the matrix of pure molybdenum or of molybdenum-based alloy.

4. Fuel rod cladding (4) according to any one of the preceding claims, wherein the molybdenum-based alloy comprises at least 85 wt.% of molybdenum.

5. Fuel rod cladding (4) according to any one of the preceding claims, wherein the chromium-based diffusion layer (22) is obtained through chromizing by pack cementation using a powder mixture comprising metallic chromium, and advantageously at least 15 wt.% of metallic chromium, or by chemical vapor deposition.

6. Fuel rod cladding (4) according to any one of the preceding claims, wherein the chromium-based coating (20) is obtained through physical vapor deposition or through chemical vapor deposition.

7. Fuel rod cladding (4) according to claim 6, wherein the chromium-based diffusion layer (22) is obtained through heat treatment of the chromium-based coating (20) deposited on the outer surface of the core (16).

8. Fuel rod cladding (4) according to any one of the preceding claims, wherein the outer protective layer (18) has a thickness comprised between 2 µm and 100 µm

9. Fuel rod cladding (4) according to any one of the preceding claims, further comprising an inner protective layer (26), said inner protective layer (26) being selected among:
- a chromium-based coating deposited on an inner surface of the core layer (16), said chromium-based coating (20) consisting of pure chromium or of a chromium-based alloy ;
- a chromium-based diffusion layer obtained by diffusion of chromium into the core (16) from the inner surface of the core (16).

10. Fuel rod (2) comprising a fuel rod cladding (4) according to any one of the preceding claims.

11. Method for manufacturing a fuel rod cladding (4) according to any one of claims 1 to 10, comprising steps of:
- providing a core (16) comprising a matrix consisting of pure molybdenum or of a molybdenum-based alloy; and
- forming an outer protective layer (18), the step of forming an outer protective layer (18) comprising at least one of the following steps:
- depositing a chromium-based coating (20) consisting of pure chromium or of a chromium-based alloy on an outer surface of said core (16), said deposition step comprising depositing at least one chromium-based coating layer (24); and/or
- forming a chromium-based diffusion layer (22) by diffusion of chromium into the core (16) from the outer surface of the core (16).

12. Method according to claim 11, wherein the step of forming the chromium-based diffusion layer (22) comprises chromizing by pack cementation, using a powder mixture comprising metallic chromium, and advantageously comprising at least 15 wt.% of metallic chromium.

13. Method according to claim 12, wherein said powder mixture further comprises one or more diffusion elements to improve the corrosion resistance.

14. Method according to claim 11, wherein the step of forming the chromium-based diffusion layer (22) comprises chromizing through chemical vapor deposition.

15. Method according to any one of claims 11 to 14, wherein the step of depositing the chromium-based coating (20) comprises depositing at least one chromium-based coating layer (24) of the chromium-based coating (20) through chemical vapor deposition (CVD) or through physical vapor deposition (PVD).

16. Method according to any one of claims 11 to 14, wherein the chromium-based coating (24) consists of several superposed chromium-based coating layers (24) and the step of depositing the chromium-based coating (20) comprises depositing each chromium-based coating layer (24) of the chromium-based coating (20) through chemical vapor deposition (CVD) or through physical vapor deposition (PVD).

17. Method according to claim 11, wherein at least one chromium-based coating layer (24) of the chromium-based coating (20) is deposited on the outer surface of the core (16) prior to forming the chromium-based diffusion layer (22), and the step of forming the chromium-based diffusion layer (22) comprises a heat treatment of said at least one chromium-based coating layer (24) of the chromium-based coating (20), the heat treatment being advantageously carried out at a temperature of at least 900°C.

18. Method according to claim 11, wherein the step of depositing the chromium-based coating (20) comprises depositing several coating layers (24), at least some of the steps of depositing a coating layer (24) comprising subjecting said coating layer (24) to a heat treatment such that chromium from said coating layer (24) diffuses into an underlying coating layer (24) and/or into the core (16), the diffusion into the core (16) possibly coinciding with the step of forming the chromium-based diffusion layer (22).
